# EUROPÄISCHE PATENTANMELDUNG

(11) **EP 1 202 356 A2**
(43) Veröffentlichungstag der Anmeldung: **02.05.2002**
(21) Anmeldenummer: 01124733.5
(22) Anmeldetag: 17.10.2001
(51) Int. Cl.: H01L 35/00

(54) **Spannungsquelle in Form einer Knopfzelle**

(30) Priorität: 27.10.2000 DE 10053357
(71) Anmelder: KUNDO SYSTEMTECHNIK GmbH, D-78112 St. Georgen (DE)
(72) Erfinder: Pfeiffer, Ulrich, 78112 St. Georgen (DE)
(74) Vertreter: Goy, Wolfgang, Dipl.-Phys.

(57) **Zusammenfassung**

Eine Spannungsquelle in Form einer Knopfzelle weist in einem flachen zylindrischen Gehäuse 1 einen Thermogenerator 6 zur Erzeugung der elektrischen Spannung auf. Dabei stehen der Deckel 2 und der Boden 3 des Gehäuses 1 in wärmeleitendem und elektrischem Kontakt mit dem Thermogenerator 6. Diese Spannungsquelle in Form einer Knopfzelle ist derart in dem elektronischen Gerät anzuordnen und einzubauen, daß der Deckel 2 und der Boden 3 auf unterschiedlichen Temperaturniveaus liegen.

## Beschreibung

Die Erfindung betrifft eine Spannungsquelle in Form einer Knopfzelle nach dem Oberbegriff des Anspruchs 1.

Batterien in Form von sogenannten Knopfzellen sind bekannt. Charakteristisch für sämtliche Typen dieser Knopfzellen ist, daß sie ein flaches zylindrisches Gehäuse aufweisen. Der Boden dieses Gehäuses definiert dabei den einen Spannungspol und der Deckel den anderen Spannungspol. Innerhalb des Gehäuses befindet sich ein elektrochemisches Element, welches ein elektrisches Potential erzeugt. Diese Knopfzellen werden in erster Linie für elektrische Kleingeräte verwendet, wie beispielsweise Armbanduhren, Hörgeräte etc.

Der Nachteil dieser Knopfzellen besteht darin, daß sie aufgrund ihrer Größe nur relativ wenig elektrische Energie speichern können. Dies bedeutet, daß sie schon nach verhältnismäßig kurzer Zeit erschöpft sind und gegen eine neue Batterie ausgewechselt werden müssen. Darüber hinaus sind diese Knopfzellen nicht für größere elektrische bzw. elektronische Geräte geeignet, welche mehr elektrische Energie benötigen.

Davon ausgehend liegt der Erfindung die **Aufgabe** zugrunde, eine Spannungsquelle in Form einer Knopfzelle mit einer verlängerten Lebensdauer zu schaffen.

Die technische **Lösung** ist gekennzeichnet durch die Merkmale im Kennzeichen des Anspruchs 1.

Die Grundidee der erfindungsgemäßen Spannungsquelle besteht darin, in dem Gehäuse einer Knopfzelle nicht mehr wie bisher ein elektrochemisches Element zu integrieren, sondern vielmehr einen Thermogenerator. Die Funktionsweise der Thermogeneratoren beruht auf dem Seebeck-Effekt, wonach aufgrund eines Temperaturunterschiedes zwischen zwei verschiedenen metallischen Leitern eine elektrische Spannung erzeugt wird. Da es heutzutage bekannt ist, derartige Thermogeneratoren mit einem mikrotechnologischen Verfahren auf einem Halbleitermaterial anzuordnen, kann eine sogenannte Thermomatrix aus einer Vielzahl von einzelnen Thermoelementen gebildet werden mit dem Vorteil, daß eine genügend hohe Spannung erzeugt werden kann, wie sie für die Knopfzellen üblich ist (siehe DE 44 25 972 A1). Grundvoraussetzung für die Spannungserzeugung ist, daß eine Temperaturdifferenz zwischen den beiden Seiten des Gehäuses der "Knopfzelle" besteht. Dies kann beispielsweise dadurch erreicht werden, daß die eine Seite der Knopfzelle zu der körperwarmen Seite eines Menschen oder zu der Heizkörperseite hin ausgerichtet ist, während die andere Seite in Kontakt mit der Umgebungstemperatur steht. Da die Hauttemperatur des Menschen in der Regel höher ist als die Umgebungstemperatur, wird dadurch die notwendige Temperaturdifferenz geschaffen und in dem Thermogenerator die gewünschte Spannung erzeugt. Voraussetzung ist natürlich, daß die Spannungsquelle derart in dem elektrischen/elektronischen Gerät eingebaut ist, daß die Erzeugung dieser notwendigen Temperaturdifferenz möglich ist. Anwendungsgebiete sind beispielsweise die Integration einer derartigen Knopfzelle mit Thermogenerator in Armbanduhren sowie in Hörgeräten, welche naturgemäß direkt auf der Haut getragen werden. Weitere Anwendungsgebiete sind beispielsweise sehr flache Heizkostenverteiler sowie andere Chip-Kartenlösungen. Weiterhin kann bei Meßgeräten, beispielsweise Wärmemengenzählern die Meßgenauigkeit erhöht werden, ohne daß dadurch die Batteriekapazität vergrößert werden muß. Der Vorteil der erfindungsgemäßen Spannungsquelle besteht darin, daß damit eine nahezu unerschöpfliche Energiequelle zum Betreiben elektrischer/elektronischer Geräte zur Verfügung steht. Dadurch können in heutzutage existierenden Geräten die Knopfzellen auf elektrochemischer Basis durch diese neuartigen "Knopfzellen" unter Verwendung eines Thermogenerators ersetzt werden. Da erfindungsgemäß durch die Verwendung eines Thermogenerators bei einer Temperaturdifferenz die Spannung immer zur Verfügung steht und somit quasi keine elektrische Energie gespeichert werden muß, können mittels der erfindungsgemäßen Spannungsquelle auch die großvolumigen zylindrischen Batterien ersetzt werden. Insgesamt werden durch die langlebigen erfindungsgemäßen Spannungsquellen die Kosten reduziert. Ein weiterer Vorteil besteht darin, daß die Abfallmengen an verbrauchten Batterien reduziert werden. Die an sich sehr schlagempfindlichen Thermogeneratoren aus Silizium sind in dem Gehäuse der "Knopfzelle" geschützt und können nicht beschädigt werden. Der Thermogenerator ist durch seine Integration auf Silizium sehr klein und kann in länglicher Form oder quadratischer Form hergestellt werden. Da die Thermogeneratoren in das Knopfzellengehäuse integriert werden, unterliegen sie denselben Einbaumaßen wie bei den Batterien, was die - bereits zuvor erwähnte - Vereinheitlichung und Austauschbarkeit der herkömmlichen Knopfzellen zur Folge hat.

Die Weiterbildung gemäß Anspruch 2 hat den Vorteil, daß dadurch ein sehr guter Wärmeübertrag zwischen dem Thermogenerator und dem Deckel einerseits und dem Boden andererseits gewährleistet ist. Unter der sandwichartigen Bauweise ist zu verstehen, daß der flächenförmige Thermogenerator parallel zu dem Deckel sowie zu dem Boden ausgerichtet ist. Dadurch ergibt sich eine sehr große Kontaktfläche für einen optimalen Wärmefluß.

Damit die Temperaturdifferenz zwischen den beiden Seiten des Gehäuses auf einem maximalen Wert gehalten werden kann, schlägt die Weiterbildung gemäß Anspruch 3 vor, daß der Thermogenerator auf einer thermischen Isolationsplatte angeordnet ist. Somit dient diese Isolationsplatte nicht nur als Halter für den Thermogenerator, sondern sie schafft auch eine optimale Energieausbeute.

Dabei kann es sich gemäß der Weiterbildung in Anspruch 4 um eine Leiterplatte handeln.

Die Weiterbildung gemäß Anspruch 5 hat den Vorteil, daß dadurch die benötigte Energie von dem Thermogenerator im Sinne eines Power-Managements auf ein Minimum reduziert wird.

Um den Wärmeübertrag zwischen dem Deckel bzw. dem Boden des Gehäuses und dem Thermogenerator zu verbessern, wird gemäß der Weiterbildung in Anspruch 6 ein die Wärmeleitung förderndes Wärmeelement als Zwischenschicht vorgeschlagen. Dabei kann es sich um eine hochwärmeleitende Silikonverbundfolie handeln. Der Vorteil besteht darin, daß dadurch ein direkter Wärmekontakt geschaffen ist und damit die beiden Seiten des Thermogenerators die Temperatur des Deckels sowie des Bodens annehmen.

Die Weiterbildung gemäß Anspruch 7 schafft eine Möglichkeit, um den Deckel und den Boden zur Schaffung eines geschlossenen Gehäuses miteinander dicht zu verbinden und insbesondere bezüglich zueinander zu fixieren. Somit ist der Thermogenerator sowie gegebenenfalls weitere Elemente innerhalb des Gehäuses fixiert.

Eine erste Ausführungsform gemäß Anspruch 8 schlägt vor, daß der Deckel sowie der Boden im wesentlichen jeweils plattenförmig ausgebildet sind. Sie sind dabei in etwa identisch.

Alternativ ist es gemäß der Weiterbildung in Anspruch 9 auch denkbar, daß der Deckel und/oder der Boden umfangsrandseitig einen Ringwulst aufweisen. Diese Topfausbildung des Deckels und/oder des Bodens hat zum einen den Vorteil, daß damit die Oberfläche zur Wärmeübertragung vergrößert wird, zum anderen wird dadurch eine Möglichkeit geschaffen, um die Spannung auch seitlich am Flachzylinder abzugreifen.

Eine weitere Weiterbildung gemäß Anspruch 10 schlägt schließlich vor, daß zusätzlich zu dem Thermogenerator noch ein elektrochemisches Element in dem Gehäuse angeordnet ist. Die Grundüberlegung ist dabei folgende: Der Thermogenerator erzeugt die entsprechende Spannung. Sie kann sofort zur Spannungsversorgung eines elektronischen Gerätes verwendet werden. Sofern jedoch die notwendige Temperaturdifferenz zum Betreiben des Thermogenerators nicht zu Verfügung steht, wird auch keine Spannung erzeugt mit der Folge, daß das elektronische Gerät nicht betrieben werden kann. Sofern ein zusätzliches elektrochemisches Element vorgesehen ist, kann dennoch das elektronische Gerät mit Spannung versorgt werden. Bei dem elektrochemischen Element kann es sich um ein Primärelement handeln. Sofern es sich bei dem elektrochemischen Element um ein Sekundärelement handelt, kann die von dem Thermogenerator erzeugte elektrische Energie durch Aufladen des Sekundärelements zwischengespeichert werden.

Zwei Ausführungsbeispiele einer erfindungsgemäßen Spannungsquelle in Form einer Knopfzelle werden nachfolgend anhand der Zeichnungen beschrieben. In diesen zeigt:

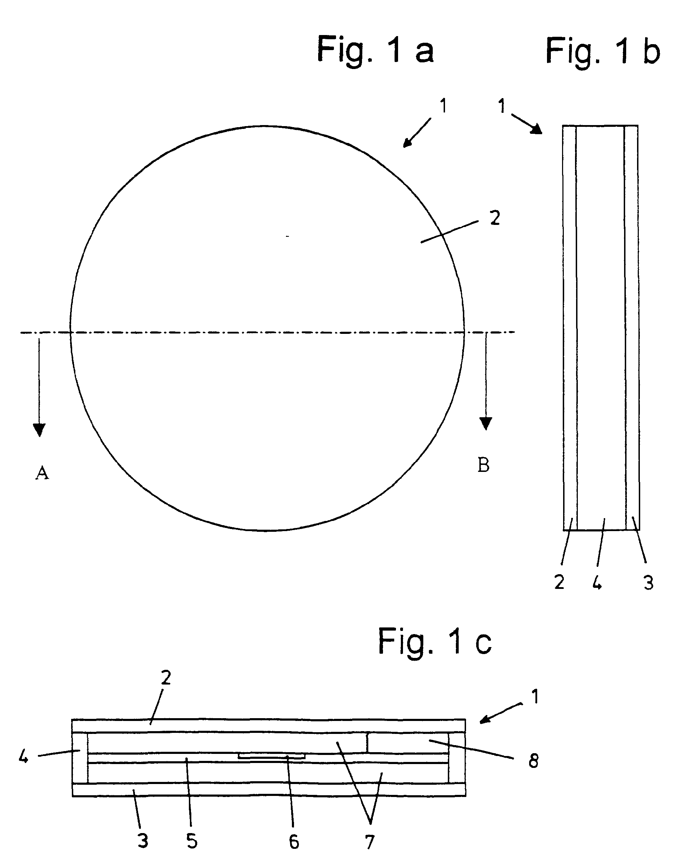

- Fig. 1 a: eine Draufsicht auf eine erste Ausführungsform der Spannungsquelle;
- Fig. 1 b: einen Schnitt entlang der Linie A-B in Fig. 1 a
- Fig. 1 c: eine Seitenansicht der Spannungsquelle in Fig. 1 a;
- Fig. 2 a: eine Draufsicht auf eine zweite Ausführungsform der Spannungsquelle;

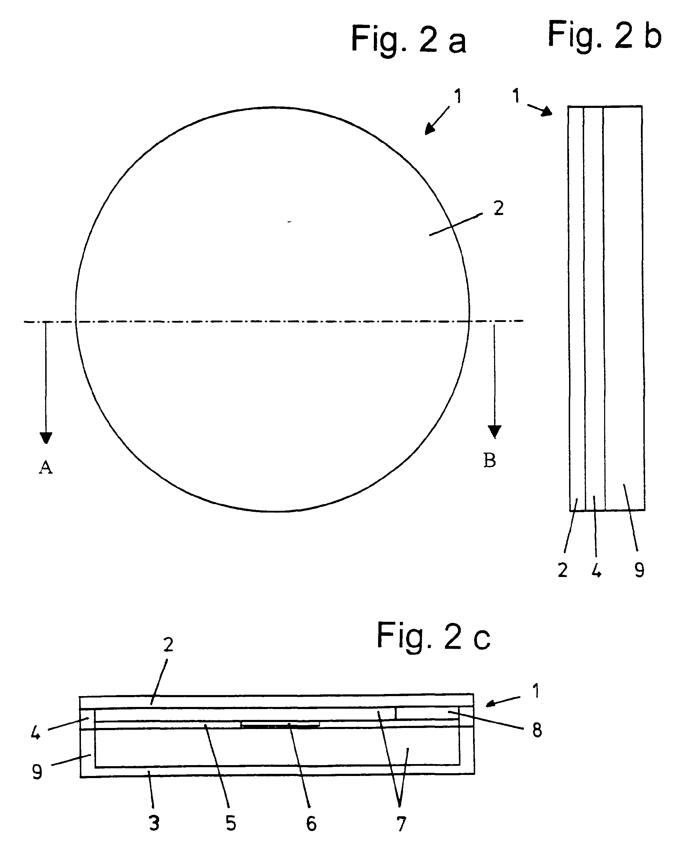

- Fig. 2 b: einen Schnitt entlang der Linie A-B in Fig. 2 a
- Fig. 2 c: eine Seitenansicht der Spannungsquelle in Fig. 2 a.

Die Spannungsquelle in Form einer sogenannten Knopfzelle der ersten Ausführungsform in Fig. 1 a bis 1 c weist ein Gehäuse 1 auf. Dieses Gehäuse 1 besteht aus einem Deckel 2 sowie einem Boden 3. Deckel 2 und Boden 3 sind jeweils als runde Platten ausgebildet. Auf Abstand gehalten werden der Deckel 2 und der Boden 3 durch einen Abstandsring 4 im Umfangsbereich. Dieser Abstandsring 4 ist dabei nicht nur elektrisch isolierend, sondern auch wärmeisolierend.

Im Innern des Gehäuses 1 befindet sich eine thermische Isolationsplatte 5 in Form einer Leiterplatte. Auf dieser Isolationsplatte 5 ist ein Thermogenerator 6 angeordnet. Beidseits der Isolationsplatte 5 bzw. des Thermogenerators 6 befindet sich jeweils ein Wärmeleitelement 7 in Form einer hochwärmeleitenden Silikonverbundfolie.

Rein schematisch ist noch ein elektrochemisches Element 8 innerhalb des Gehäuses 1 in Form eines Primärelements oder eines Sekundärelements angedeutet.

Die Funktionsweise der Spannungsquelle ist wie folgt:

Die Spannungsquelle wird in einem - nicht dargestellten - Gerät dergestalt eingebaut, daß zwischen dem Deckel 2 und dem Boden 3 des Gehäuses 1 eine Temperaturdifferenz besteht. Dies kann beispielsweise dadurch erreicht werden, daß der Boden 3 des Gehäuses 1 der Hautoberfläche zugewandt ist, während der Deckel 2 der Umgebungsluft ausgesetzt ist. Durch die hochwärmeleitenden Wärmeleitelemente 7 werden die beiden Seiten des Thermogenerators 6 auf die entsprechende Temperatur gebracht. Aufgrund des Seebeck-Effektes wird dann eine Spannung erzeugt, welche an den beiden Spannungspolen, nämlich dem Deckel 2 und dem Boden 3 anliegen. Die elektrischen Verbindungen zwischen dem Thermogenerator 6 und dem Deckel 2 und dem Boden 3 sind im übrigen in den Zeichnungen nicht dargestellt.

Die zweite Ausführungsform der Fig. 2 a bis 2 c unterscheidet sich von der ersten Ausführungsform dadurch, daß der Boden 3 nicht mehr plattenförmig, sondern vielmehr topfförmig ausgebildet ist und einen Ringwulst 9 aufweist. Dieser Topf ist mit dem unteren Wärmeelement 7 voll ausgefüllt. Zwischen dem Ringwulst 9 des Bodens 3 und dem - nach wie vor-plattenförmigen Deckel 2 ist der Abstandsring 4 angeordnet, welcher jedoch im Gegensatz zu der Ausführungsform der Fig. 1 a bis 1 c eine geringere Höhe aufweist. Der Vorteil des so ausgebildeten Bodens 3 besteht darin, daß dadurch eine vergrößerte Wärmeabgabeoberfläche gegeben ist.

### Bezugszeichenliste

- 1: Gehäuse
- 2: Deckel
- 3: Boden
- 4: Abstandsring
- 5: Isolationsplatte
- 6: Thermogenerator
- 7: Wärmeleitelement
- 8: elektrochemisches Element
- 9: Ringwulst

## Patentansprüche

1. Spannungsquelle in Form einer Knopfzelle
mit einem flachen zylindrischen, einen Deckel (2) sowie einen Boden (3) aufweisenden Gehäuse (1), wobei der Deckel (2) und der Boden (3) die beiden Spannungspole bilden, sowie
mit einem innerhalb des Gehäuses (1) angeordneten, eine elektrische Spannung erzeugenden Element,
dadurch gekennzeichet,
daß das die elektrische Spannung erzeugende Element ein Thermogenerator (6) ist,
daß der Deckel (2) und der Boden (3) des Gehäuses (1) im wärmeleitenden Kontakt mit den beiden unterschiedlichen wärmesensitiven Bereichen des Thermogenerators (6) stehen und
daß zur Spannungserzeugung der Deckel (2) sowie der Boden (3) des Gehäuses (1) auf unterschiedlichen Temperaturniveaus liegen.

2. Spannungsquelle nach dem vorhergehenden Anspruch,
**dadurch gekennzeichnet,**
**daß** der Thermogenerator (6) sandwichartig zwischen dem Deckel (2) und dem Boden (3) eingebettet ist.

3. Spannungsquelle nach einem der vorhergehenden Ansprüche,
**dadurch gekennzeichnet,**
**daß** der Thermogenerator (6) auf einer thermischen Isolationsplatte (5) angeordnet ist.

4. Spannungsquelle nach Anspruch 3,
**dadurch gekennzeichnet,**
**daß** die elektrische Isolationsplatte (5) eine Leiterplatte ist.

5. Spannungsquelle nach Anspruch 4,
**dadurch gekennzeichnet,**
**daß** auf der Leiterplatte eine elektronische Schaltung für die Steuerung der elektrischen Leistungsabgabe der Spannungsquelle angeordnet ist.

6. Spannungsquelle nach einem der vorhergehenden Ansprüche,
**dadurch gekennzeichnet,**
**daß** zwischen dem Thermogenerator (6) und dem Deckel (2) sowie zwischen dem Thermogenerator (6) und dem Boden (3) jeweils ein die Wärmeleitung förderndes Wärmeleitelement (7) angeordnet ist.

7. Spannungsquelle nach einem der vorhergehenden Ansprüche,
**dadurch gekennzeichnet,**
**daß** zwischen dem Umfangsrand des Deckels (2) und dem Umfangsrand des Bodens (3) ein elektrisch isolierender Abstandsring (4) angeordnet ist.

8. Spannungsquelle nach einem der Ansprüche 1 bis 7,
**dadurch gekennzeichnet,**
**daß** der Deckel (2) und der Boden (3) jeweils plattenförmig ausgebildet sind.

9. Spannungsquelle nach einem der Ansprüche 1 bis 7,
**dadurch gekennzeichnet,**
**daß** der Deckel (2) und/oder der Boden (3) umfangsrandseitig einen Ringwulst (9) aufweist.

10. Spannungsquelle nach einem der vorhergehenden Ansprüche,
**dadurch gekennzeichnet,**
**daß** zusätzlich zu dem Thermogenerator (6) ein elektrochemisches Element (8) in dem Gehäuse (1) angeordnet ist.
